(19) Europäisches Patentamt
European Patent Office
Office européen des brevets

(11) **EP 3 356 078 B1**

(12) **EUROPÄISCHE PATENTSCHRIFT**

(45) Veröffentlichungstag und Bekanntmachung des Hinweises auf die Patenterteilung:
**18.05.2022 Patentblatt 2022/20**

(21) Anmeldenummer: **16826322.6**

(22) Anmeldetag: **21.12.2016**

(51) Internationale Patentklassifikation (IPC):
**B23K 26/06** *(2014.01)* **B28D 1/22** *(2006.01)*
**B28D 5/00** *(2006.01)* **B23K 26/40** *(2014.01)*
**H01L 23/373** *(2006.01)* **B23K 26/364** *(2014.01)*
**C04B 37/02** *(2006.01)* **C03B 33/02** *(2006.01)*
**C03B 33/09** *(2006.01)*

(52) Gemeinsame Patentklassifikation (CPC):
**B23K 26/0626; B23K 26/364; B23K 26/40; C03B 33/0222; C04B 37/026; H01L 21/4807; H01L 23/3735;** C04B 2235/665; C04B 2237/343; C04B 2237/366; C04B 2237/368; C04B 2237/407; C04B 2237/704

(86) Internationale Anmeldenummer:
**PCT/EP2016/082180**

(87) Internationale Veröffentlichungsnummer:
**WO 2017/108950 (29.06.2017 Gazette 2017/26)**

(54) **VERFAHREN ZUR HERSTELLUNG EINES METALLISIERTEN KERAMIK SUBSTRATES MIT HILFE VON PICOLASERN ; ENTSPRECHEND METALLISIERTES KERAMIKSUBSTRAT**

METHOD OF PRODUCING A METALLISED CERAMIC SUBSTRATE USING PICOLASER ; CORRESPONDING METALLISED CERAMIC SUBSTRATE

PROCÉDÉ DE FABRICATION D'UN SUBSTRAT EN CÉRAMIQUE MÉTALLISÉ À L'AIDE D'UN PICOLASER ; SUBSTRAT CÉRAMIQUE MÉTALLISÉ CORRESPONDANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.12.2015 EP 15201873**

(43) Veröffentlichungstag der Anmeldung:
**08.08.2018 Patentblatt 2018/32**

(73) Patentinhaber: **Heraeus Deutschland GmbH & Co. KG**
**63450 Hanau (DE)**

(72) Erfinder:
• **ROGG, Alexander**
**92724 Trabitz (DE)**

• **WACKER, Richard**
**96135 Stegaurach (DE)**

(74) Vertreter: **Gille Hrabal Partnerschaftsgesellschaft mbB**
**Patentanwälte**
**Brucknerstraße 20**
**40593 Düsseldorf (DE)**

(56) Entgegenhaltungen:
EP-A1- 2 754 524       WO-A1-03/078353
WO-A2-2004/113041    WO-A2-2014/035504
DE-A1-102013 104 055   JP-A- 2005 271 563
US-A1- 2003 213 770     US-A1- 2004 259 329
US-A1- 2015 038 313

**Beschreibung**

Die vorliegende Erfindung betrifft ein Verfahren zum Bearbeiten von metallisierten Keramiksubstraten sowie ein metallisiertes Keramiksubstrat gemäß den Ansprüchen 1 und 10.

Metall-Keramik-Substrate, welche beispielsweise nach den DCB-, AMB- und DAB-Verfahren erhalten werden, sind dem Fachmann bekannt, siehe z.B. US 2003/213770 A1 (Basis für den Oberbegriff der Ansprüche 1 und 10). Diese Metall-Keramik-Substrate werden üblicherweise im sogenannten Mehrfachnutzen produziert. Bei diesem Mehrfachnutzen weisen die Keramik-Substrate zumindest an einer Oberflächenseite, vorzugsweise aber an beiden Oberflächenseiten der Keramikschicht, Einzelmetallisierungen auf, zwischen denen Sollbruchlinien in der Keramikschicht verlaufen, sodass durch Brechen entlang dieser Sollbruchlinien das großflächige Metall-Keramik-Substrat in Einzelsubstrate getrennt werden kann, die dann jeweils die Leiterplatte eines Schaltkreises oder Moduls bilden können.

Ein Teilschritt des Herstellungsverfahrens von derartigen Metall-Keramik-Substraten im Mehrfachnutzen ist das Separieren der Einzelteile aus dem Mehrfachnutzen heraus, was üblicherweise mittels Laser erfolgt. Hierbei kommen in der Regel $CO_2$-Resonatoren mit beispielsweise 250 bis 400 Watt zum Einsatz. Durch den Laser werden dicht aneinander gereihte Sacklöcher erzeugt. Diese Sacklöcher bilden eine Sollbruchlinie (Perforation).

Der in diesem Teilschritt verwendete Bewegungsapparat ist üblicherweise mit einem x-y-Tisch für das Metall-Keramik-Substrat und einem starren Laser ausgestattet, da ein $CO_2$-Laser mit einer Wellenlänge von etwa 10,6 $\mu$m nicht lichtfaserleitfähig ist und sich mit einem Bewegen der Optik die Länge des optischen Weges und somit die Strahlqualität ändert.

Zum Fokussieren des Lasers wird eine Linse verwendet. Zu deren Schutz wiederum wird ein Prozessgas verwendet (z.B. Druckluft oder Sauerstoff), das gemeinsam mit dem Laserlicht aus einer Prozessgasdüse austritt. Auf diese Weise wird verhindert, dass aus dem Substrat herausgeschleudertes, teilweise schmelzflüssiges Material die Linse verunreinigt (das Prozessgas verhindert das Eindringen von Verunreinigungen in die Düse). Gleichzeitig dient das Prozessgas allerdings auch dazu, dass geschmolzene Material aus dem Laserkegel heraus zu blasen.

Aufgrund der häufig bestehenden unterschiedlichen Anforderungen an das Ritzen (einerseits wird die Erzeugung einer Sollbruchlinie gefordert und andererseits wird ein Schneiden oder Bohren, also ein Durchschneiden des Substrats, verlangt) sind die entsprechenden Vorrichtungen zum Bearbeiten der Metall-Keramik-Substrate häufig mit zwei unterschiedlichen Prozessdüsen ausgestattet.

Ein Nachteil der bekannten Verfahren besteht darin, dass die Bearbeitung von bestückten Substraten, wie Chips und Drahtbonds, erschwert wird, da die Laserdüse nicht ausreichend nahe an die Substratoberfläche heranreicht. Dadurch können die Laserkegel nicht ausreichend ausgeblasen werden und es verbleiben Glasphasen in den Laserkegeln zurück.

Nachteilig an den bekannten Verfahren ist auch, dass Laserstäube und -spritzer von der Oberfläche durch einen Reinigungsschritt entfernt werden müssen.

Nachteilig an den bekannten Verfahren ist ferner, dass beim Schneiden von Keramiken Grate entstehen, die mechanisch entfernt werden müssen. Daraus ergeben sich ein erhöhter Verfahrensaufwand und die Gefahr von erhöhtem Produktausschuss.

Die üblicherweise verwendeten $CO_2$-Resonatoren ermöglichen ferner nicht die Bearbeitung von Kupfer, so dass Kupfer nicht durchtrennt werden kann.

Bei den verwendeten $CO_2$-Resonaten besteht des Weiteren der Nachteil, dass beim Schneiden der Keramik der Einstichpunkt (Initial-Loch) deutlich zu erkennen ist. Hier entstehen mehr störende Schmelzphasen und Rückstände. Aufgrund des mangelhaften Erscheinungsbildes muss dieser Einstichpunkt üblicherweise in den Bereich des Ausfallteils gelegt werden, was ebenfalls einen erhöhten Aufwand für die Programmerstellung bedeutet und längere Prozesszeiten nach sich zieht.

Des Weiteren besteht Bedarf nach einem Verfahren, mit welchen Metall-Keramik-Substrate von der Rückseite gelasert werden können. Herstellungsbedingt handelt es sich hierbei um die konkave Seite des Metall-Keramik-Substrats. Dabei stehen die Ecken und Kanten des Substrats bei manchen Materialkombinationen nach oben. Zwar kann durch das Ansaugen der Metall-Substrat-Keramik die Durchbiegung reduziert werden, allerdings ist es mit den üblichen $CO_2$-Lasern nicht möglich, eine ausreichende Tiefenschärfe zu erzeugen. Daher kommt es häufig im Randbereich zu einer fehlerhaften Laserung und zu einem Ausschuss.

Ausgehend von diesem Stand der Technik stellt sich die vorliegende Erfindung die Aufgabe, die oben beschriebenen Nachteile des Standes der Technik vorzugsweise zu vermeiden.

Insbesondere stellt sich die vorliegende Erfindung die Aufgabe, ein Verfahren zum Bearbeiten von Keramiken bzw. Metall-Keramik-Substraten bereitzustellen, welches mit hoher Kosteneffizienz und hoher Prozesskapazität pro Laseranlage durchgeführt werden kann. Dabei soll sich das Verfahren insbesondere für Keramiken vom Typ $Al_2O_3$, ZTA (Zirkon-dotiertes $Al_2O_3$), AIN und $Si_3N_4$ eignen. Das Verfahren soll dabei vorzugsweise ohne die Bildung von Rückständen auf den Substraten, d.h. Laserstäuben oder Schneidgrate, erfolgen.

Das erfindungsgemäße Verfahren soll des Weiteren vorzugsweise ein Einbringen einer möglichst fehlerfrei brechenden Sollbruchlinie bzw. Laserritzlinie ermöglichen, was ein Einbringen einer ausreichenden Lasertiefe sowie das Einbringen einer ausreichend Kerbwirkung erzeugender Mikrorisse erfordert. Darüber hinaus sollen die Laserritzlinien in den nachfolgenden galvanischen Prozessen vorzugsweise nicht metallisieren.

Das erfindungsgemäße Verfahren soll des Weiteren vorzugsweise eine Ablation und ein Durchschneiden von Kupfer des Metall-Keramik-Substrats ermöglichen.

Schließlich soll das erfindungsgemäße Verfahren es vorzugsweise ermöglichen, Keramiksubstrate, die beispielsweise mit Chips und Drahtbonds bestückt sind, zu bearbeiten, ohne die Nachteile in Kauf nehmen zu müssen, die auftreten, wenn der Laserkegel nicht ausgeblasen wird.

Gelöst werden diese Aufgaben durch ein Verfahren zum Bearbeiten von metallisierten Keramiksubstraten entsprechend Anspruch 1, bei welchem

    a. eine Laserritzlinie als Sollbruchlinie in dem Metall-Keramik-Substrat unter Verwendung eines Laserstrahls erzeugt wird; und/oder

    b. ein zumindest teilweises Durchschneiden des Metall-Keramik-Substrats unter Verwendung eines Laserstrahls erfolgt.

Das erfindungsgemäße Verfahren ist dann dadurch gekennzeichnet, dass die Bearbeitung unter Verwendung eines Lasers erfolgt und bei der Erzeugung der Laserritzlinie als Sollbruchlinie oder bei dem Durchschneiden eine Pulsdauer des Lasers verwendet wird, die so gewählt wird, dass im Wesentlichen keine Schmelzphasen des Keramikmaterials gebildet werden.

Das erfindungsgemäße Verfahren ist unabhängig hiervon auch allgemein dadurch gekennzeichnet, dass bei der Erzeugung der Laserritzlinie als Sollbruchlinie oder bei dem Durchschneiden der Metall-Keramik-Substrats Verfahrensbedingungen des Lasers verwendet werden, die so gewählt sind, dass im Wesentlichen keine Schmelzphasen des Keramikmaterials gebildet werden.

Glasphasen sind Rückstände in der Laserritzlinie, die vom Laser erhitzt und aufgeschmolzen werden, die aber nicht aus der Ritzlinie entfernt werden und sich in der Laserritzlinie verfestigen.

Im Rahmen der vorliegenden Erfindung wird unter dem Merkmal "im Wesentlichen keine Schmelzphasen des Keramikmaterials" verstanden, wenn in der Laserritzlinie weniger als 30 Vol.-%, bevorzugt weniger als 20 Vol.-%, weiter bevorzugt weniger als 15 Vol.-%, sowie mehr als 0,1 Vol.-%, bevorzugt mehr als 0,5 Vol.-%, weiter bevorzugt mehr als 1,0 Vol.-%, Schmelzphase enthält.

Diese Menge an Schmelzphase bildet sich an der Oberfläche (oberflächliche Belegung). Diese Schmelzphase zeichnet sich dadurch aus, dass sie Mikrorisse aufweisen, die für das anschließende Brechen der Keramik bevorzugte Kerbwirkungen und Spannungserhöhungen verursachen.

Im Rahmen der vorliegenden Erfindung ist es bevorzugt, wenn die Laserritzlinien geringe Mengen an Schmelzphasen, d.h. gemäß der Erfindung die oben beschriebenen Mindestmengen an Schmelzphasen, umfasst.

Die Bildung von zu großen Mengen an Schmelzphasen des Keramikmaterials können vermieden werden, wenn der Laser unter bestimmten Verfahrensbedingungen betrieben wird. Hierzu zählen insbesondere

    (a) die Pulsdauer des Lasers;

    (b) die Eindringtiefe des Laser in das Metall-Keramik-Substrat; sowie

    (c) der Leistung des Lasers.

Im Folgenden werden bevorzugte Ausführungsformen des Lasers beschrieben, mit welchem eine Bildung von Schmelzphasen bei Bearbeitung der Keramik im Wesentlichen verhindert werden können.

In dem erfindungsgemäßen Verfahren ist es möglich, dass bei der Erzeugung der Laserritzlinie als Sollbruchlinie die Laserritzlinie in einer Überfahrt oder in mehreren Überfahrten des Lasers erzeugt wird (Alternative

    a.). Auch das Durchschneiden des Metall-Keramik-Substrats kann in mehreren Überfahrten des Lasers erreicht werden (Alternative
    b.). Im Rahmen der vorliegenden Erfindung ist der ausgewählte Laser ein p-sec-Laser.

Ferner ist weiter bevorzugt, wenn der p-sec-Laser eine Pulsdauer, d.h. eine Dauer des Laserpulses, von vorzugsweise 0,1 bis 100 ps, weiter bevorzugt 0,5 bis 50 ps, noch weiter bevorzugt 1 bis 30 ps, aufweist. Mit der gewählten Pulsdauer ist es möglich, den Laserprozess so zu führen, dass im Wesentlichen keine Schmelzphasen entstehen und somit im Wesentlichen keine Laserspritzer und Laserstäube, die sich auf der Substratoberfläche niederschlagen, gebildet werden. Gleichzeitig wird mit dieser Pulsdauer eine ausreichende Kerbwirkung in der Laserritzlinie erreicht. Da im Rahmen der vorliegenden Erfindung im Wesentlichen nur kalte Stäube und keine Schmelzphasen entstehen und aufgrund eines ausreichend groß gewählten Abstandes von Strahlquelle zu Substratoberfläche ist die Verwendung eines Prozessgases zwar möglich, nicht jedoch zwingend erforderlich.

Die Pulsenergie, d.h. der Energiegehalt eines einzelnen Laserpulses, beträgt vorzugsweise 10 bis 500 μJ, weiter bevorzugt 50 bis 400 μJ, noch weiter bevorzugt 100 bis 350 μJ.

Der p-sec-Laser weist vorzugsweise eine Leistung von 20 bis 400 W, weiter bevorzugt 40 bis 200 W, noch weiter bevorzugt 50 bis 180 W, noch weiter bevorzugt 60 bis 160 Watt, noch weiter bevorzugt 80 bis 130 Watt, noch weiter bevorzugt 90 bis 120 Watt, auf.

Die Bearbeitungsgeschwindigkeit des Lasers beträgt gemäß der Erfindung mindestens 0,05 m/sec, weiter bevorzugt mindestens 0,1 m/sec, weiter bevorzugt mindestens 0.15 m/sec, weiter bevorzugt mindestens 0,20 m/sec, weiter bevorzugt mindestens 0,25 m/sec.

Die Bearbeitungsgeschwindigkeit des Lasers beträgt gemäß der Erfindung höchstens 19,0 m/sec, weiter bevorzugt höchstens 18,0 m/sec, weiter bevorzugt höchstens 17,0 m/sec, weiter bevorzugt höchstens 16,0 m/sec.

Die Bearbeitungsgeschwindigkeit des Lasers beträgt vorzugsweise 0,05 bis 20,0 m/sec, weiter bevorzugt 0,1 bis 19,0 m/sec, weiter bevorzugt 0,15 bis 18,0 m/sec, weiter bevorzugt 0,20 bis 17,0 m/sec, weiter bevorzugt 0,25 bis 16,0 m/sec.

Die Bearbeitungsgeschwindigkeit entspricht dabei der Realgeschwindigkeit, mit welcher sich der Laser über die Keramik bewegt. Entsprechende analoge Ergebnisse lassen sich erzielen, wenn Effektivgeschwindigkeiten des Lasers gewählt werden, bei denen die oben definierte erfindungsgemäße Realgeschwindigkeiten durch die Anzahl an Überfahrten des Lasers geteilt werden, wobei man von 2 bis 50, vorzugsweise 2 bis 40, weiter bevorzugt 2 bis 30, weiter bevorzugt 2 bis 20, Überfahrten ausgehen kann.

Überraschenderweise hat sich ferner herausgestellt, dass ein Zusammenhang zwischen verwendeter Resonatorleistung (x in Watt) des Lasers und maximaler realer Bearbeitungsgeschwindigkeit (y in m/sec) des Lasers besteht.

Der Zusammenhang folgt allgemein folgender Funktion:

$$y = \sqrt{2,3 \bullet x - 40}$$

Hierbei sind die maximalen Bearbeitungsgeschwindigkeiten von der Dicke der Keramik unabhängig.

Sind die realen Bearbeitungsgeschwindigkeiten größer als allgemein oben angegeben oder durch die oben stehende Formel berechnet ist ein wirkungsvolles und sicheres Brechen der Keramiksubstrate entlang der Laserritzlinie nicht möglich.

In einer weiteren bevorzugten Ausführungsform beträgt die Bearbeitungsgeschwindigkeit des Lasers vorzugsweise mindestens 0,05 m/sec bis zu einer maximalen Bearbeitungsgeschwindigkeit in m/sec, die sich durch die oben genannte Formel

$$y = \sqrt{2,3 \bullet x - 40}$$

ergibt, wobei x der Resonatorleistung des Laser in W entspricht.

In einer weiteren bevorzugten Ausführungsform beträgt die Bearbeitungsgeschwindigkeit des Lasers vorzugsweise mindestens 0,1 m/sec bis zu einer maximalen Bearbeitungsgeschwindigkeit in m/sec, die sich durch die oben genannte Formel

$$y = \sqrt{2,3 \bullet x - 40}$$

ergibt, wobei x der Resonatorleistung des Laser in W entspricht.

In einer weiteren bevorzugten Ausführungsform beträgt die Bearbeitungsgeschwindigkeit des Lasers vorzugsweise mindestens 0,15 m/sec bis zu einer maximalen Bearbeitungsgeschwindigkeit in m/sec, die sich durch die oben genannte Formel

$$y = \sqrt{2,3 \bullet x - 40}$$

 ergibt, wobei x der Resonatorleistung des Laser in W entspricht.

In einer weiteren bevorzugten Ausführungsform beträgt die Bearbeitungsgeschwindigkeit des Lasers vorzugsweise mindestens 0,20 m/sec bis zu einer maximalen Bearbeitungsgeschwindigkeit in m/sec, die sich durch die oben genannte Formel

$$y = \sqrt{2,3 \bullet x - 40}$$

ergibt, wobei x der Resonatorleistung des Laser in W entspricht.

In einer weiteren bevorzugten Ausführungsform beträgt die Bearbeitungsgeschwindigkeit des Lasers vorzugsweise mindestens 0,25 m/sec bis zu einer maximalen Bearbeitungsgeschwindigkeit in m/sec, die sich durch die oben genannte Formel

$$y = \sqrt{2,3 \bullet x - 40}$$

ergibt, wobei x der Resonatorleistung des Laser in W entspricht.

Der Spot-Durchmesser des Lasers beträgt vorzugsweise 20 bis 80 $\mu$m, weiter bevorzugt 30 bis 70 $\mu$m, noch weiter bevorzugt 40 bis 60 $\mu$m.

Gemäß der Erfindung handelt es sich bei dem verwendeten Laser um einen IR-Laser.

Die zugrundeliegenden Aufgaben der vorliegenden Erfindungen werden gemäß der Erfindung durch die Verwendung eines p-sec-IR-Lasers, gelöst, wobei, ohne an eine Theorie gebunden zu sein, davon ausgegangen wird, dass das Licht des p-sec- IR-Strahls in die Oberfläche des Keramiksubstrats bzw. in die Oberfläche der Metallbeschichtung besonders wirkungsvoll einkoppelt, d.h. von dem Keramiksubstrat bzw. der Metallbeschichtung besonders wirkungsvoll absorbiert wird. Darüber hinaus weist ein IR-Laser eine hohe Energieeffizienz auf, was zur Lösung der obenstehenden Aufgaben ebenfalls von Vorteil ist.

Ein weiterer Vorteil der Verwendung von einem IR-Laser zur Bearbeitung von Keramiksubstraten bzw. Metall-Keramik-Substraten ist, dass das IR-Laserlicht direkt aus Diodenlicht erzeugt werden kann, wohingegen grünes Laserlicht erst aus IR-Laserlicht mit einem Wirkungsgrad von 60 % hergestellt werden muss und UV-Laserlicht wiederum aus grünem Laserlicht mit einem weiteren Wirkungsgrad von ebenfalls 60 % hergestellt werden muss.

Im Gegensatz zu beispielsweise einem $CO_2$-Laser kann der p-sec-IR-Laser deutlich weiter von dem zu strukturierenden Metall-Keramik-Substrat entfernt angeordnet werden, wodurch sich eine höhere Tiefenschärfe realisieren lässt.

Mithilfe eines IR-Lasers kann darüber hinaus gegenüber einem $CO_2$-Laser eine ausreichend hohe Tiefenschärfe realisiert werden.

Wenn im Rahmen der vorliegenden Erfindung ein IR-Laser verwendet wird, so beträgt die Frequenz des IR-Lasers vorzugsweise 350 bis 650 kHz, weiter bevorzugt 375 bis 625 kHz, noch weiter bevorzugt 400 bis 600 kHz.

Wenn im Rahmen der vorliegenden Erfindung ein IR-Laser verwendet wird, so beträgt die Pulsenergie des IR-Lasers vorzugsweise 100 bis 300 $\mu$J, weiter bevorzugt 125 bis 275 $\mu$J, noch weiter bevorzugt 150 bis 250 $\mu$J.

Das erfindungsgemäße Verfahren gemäß den Alternativen a. und b. kann in Gegenwart eines Prozessgases durchgeführt werden. Bei dem Prozessgas handelt es sich beispielsweise um Sauerstoff.

Das erfindungsgemäße Verfahren gemäß den Alternativen a. und b. wird vorzugsweise in einer Vorrichtung durchgeführt wird, die eine Absaugvorrichtung aufweist, die Stäube absorbiert, welche durch die Laserbearbeitungen entstehen.

Im Folgenden werden die Alternativen a. und b. der Bearbeitung von Keramiksubstraten bzw.

Metall-Keramik-Substraten näher beschrieben.

Alternative a : Laserritzlinie als Sollbruchlinie in dem Metall-Keramik-Substrat

Das Verfahren eignet sich in einer ersten Alternative zur Erzeugung einer Laserritzlinie als Sollbruchlinie in einem Metall-Keramik-Substrat.

Die zu erzeugende Laserritzlinie als Sollbruchlinie in dem Metall-Keramik-Substrat kann entweder durchgängig oder unterbrochen in dem Metall-Keramik-Substrat erzeugt werden. Damit ein anschließendes Brechen des Metall-Keramik-Substrats einfach und gemäß der Erfindung möglich ist, ist vorgesehen, dass die Tiefe der Laserritzlinie 5 bis 50 %, weiter bevorzugt 8 bis 45 %, noch weiter bevorzugt 10 bis 40 %, der Schichtdicke des Keramiksubstrats beträgt.

Bei einem üblichen Keramiksubstrat wird bei der Erzeugung der Laserritzlinie als Sollbruchlinie üblicherweise Parameter des Lasers, d.h. beispielsweise Pulsdauer, Frequenz und Leistung, dergestalt verwendet, dass eine Tiefe der Ritzlinie von mindestens 20 $\mu$m, weiter bevorzugt mindestens 30 $\mu$m, noch weiter bevorzugt mindestens 50 $\mu$m, jeweils bezogen senkrecht auf eine planare Oberfläche des Keramiksubstrats, erzeugt wird.

Durch das erfindungsgemäße Verfahren können Ritzlinien gestaltet werden, die je nach Bedarf hiervon abweichende Tiefen aufweisen. Beispielsweise kann das erfindungsgemäße Verfahren so ausgestaltet sein, dass die Ritztiefe im Anfangsbereich der Ritzlinie höher ist, um eine Initiierung des Bruches zu erleichtern oder um den Bruchverlauf im Übergang zwischen Schneid- und Ritzkonturen zu optimieren. Beispielsweise kann in dem Fall, in welchem die Außenkontur eines Metall-Keramik-Substrats abgerundet werden soll und daher aufgrund des geringen Rundungsradius geschnitten werden muss, sich an den Ecken des Metall-Keramik-Substrats ein Loch ergeben, in dem der Bruchverlauf aus der Ritzlinie gestoppt wird und auf der anderen Seite des Lochs wieder neu initiiert werden muss. In dem Bereich der Neueinleitung des Risses in die Laserritzlinie kann dann vorzugsweise eine höhere Ritztiefe erzeugt werden, um diesen Vorgang der Riss-Neueinleitung zu erleichtern.

Die erfindungsgemäß zu erzeugende Ritzlinie weist eine Breite von vorzugsweise 20 bis 70 $\mu$m, weiter bevorzugt 25 bis 65 $\mu$m, noch weiter bevorzugt 30 bis 60 $\mu$m, auf und verläuft in x/y-Richtung des Metall-Keramik-Substrats vorzugsweise gerade. Erfindungsgemäß ist daher bevorzugt die Bildung von Bögen oder Radien in der Laserritzlinie nicht vorgesehen. Vorzugsweise werden allenfalls zu Markierungszwecken Konturen durch das Lasern in das Metall-Keramik-Substrat eingebracht.

Wie bereits ausgeführt, wird bei der Erzeugung der Laserritzlinie als Sollbruchlinie vorzugsweise eine Pulsdauer des Lasers verwendet, die so gewählt wird, dass bei dem Lasern im Wesentlichen keine Schmelzphasen des Keramikmaterials gebildet werden.

Damit weist die Ritzlinie im Wesentlichen keine Verglasungen an den Seiten der Ritzlinie auf (sogenannter Laseraufwurf). Innerhalb der Ritzlinie selber befinden sich vorzugsweise im Wesentlichen keine, zumindest jedoch kaum Rückstände von Glasphasen (d.h. durch den Laser aufgeschmolzenes, aber nicht entferntes Material). Ferner scheiden sich bei der erfindungsgemäßen Verfahrensweise seitlich der Laserritzlinie im Wesentlichen keine (zumindest kaum) Laserstäube ab.

Die erfindungsgemäß erhaltene Laserritzlinie weist vorzugsweise Mikrorisse auf, die durch thermische Spannungen während des Lasern entstehen und für das anschließende Brechen der Ritzlinien von Vorteil sind. Darüber hinaus metallisiert die Laserritzlinie in den nachfolgenden galvanischen Verfahrensschritten vorzugsweise nicht.

Im Rahmen der vorliegenden Erfindung ist es möglich, dass die Laserritzlinie durch eine Überfahrt des Lasers über das Metall-Keramik-Substrat erzeugt wird. In einer alternativen Verfahrensweise wird die Laserritzlinie als Sollbruchlinie mit mehreren Überfahrten des Lasers erzeugt, was bevorzugt sein kann, um den spezifischen Energieeintrag, d.h. Energie pro Zeit, gering zu halten. Allerdings ist die Anzahl an Überfahrten vom Material, d.h. der Metallbeschichtung oder der verwendeten Keramik, und von der gewünschten Bearbeitungstiefe abhängig.

Die Bearbeitungsgeschwindigkeit des Lasers hängt von den konkreten Verfahrensbedingungen, d.h. dem verwendeten Laser sowie den verwendeten Materialien für Metallbeschichtung und Keramik sowie der gewünschten Bearbeitungstiefe, ab.

Die Bearbeitungsgeschwindigkeit des Lasers ist vorzugsweise wie vorstehend angegeben.

Ein weiterer Vorteil, der mit der Verwendung eines IR-Lasers einhergeht, ist die Vermeidung von Kreuzungspunkten zweier Ritzlinien. Wenn sich zwei Laserritzlinien kreuzen, besteht bei der Verwendung eines $CO_2$-Lasers die Möglichkeit, dass sich die zwei Laserpulse an derselben Stelle überlagern. Dadurch erhöht sich die Tiefe des Einschussloches. Im Extremfall kann es zu einem Durchschuss kommen, der bis auf die gegenüberliegende Keramik-Seite reicht. Das kann sich negativ auf das Brechverhalten oder auch auf die spätere mechanische Festigkeit des Substrats auswirken. Aufgrund der sehr hohen Präzision der IR-Lasertechnologie, insbesondere bei der Verwendung eines p-sec-IR-Laser, sowie der Tatsache, dass alle Ritzlinien mehrfach abgefahren werden und sich somit keine Bevorzugung einer Ritzlinie ergibt, kann einfach eine der Ritzlinien unterbrochen werden oder die Parameter im Kreuzungsbereich werden angepasst und somit eine erhöhte Ritztiefe im Kreuzungsbereich vermieden.

Ein weiterer Vorteil gegenüber der Verwendung von $CO_2$-Lasern ergibt sich beim Vorlasern von Keramiken mit dem erfindungsgemäß vorgesehenen IR-Laser, insbesondere p-sec-IR-Laser. Im Bereich der Metall-Keramik-Substrate gibt es Produkte, bei denen es vorgelaserte Keramiken verwendet werden. Hierbei wird die Keramik bereits vor dem Verbindungsprozess von Metall und Keramik gelasert. Beispiele hierfür sind Produkte mit Durchkontaktierung (Vias) oder überstehendem Metall (Lead-off). Im Fall der Bearbeitung mit $CO_2$-Lasern müssen die während des Lasern entstehenden Stäube und Laseraufwurf wieder entfernt werden. Dieses erfolgt beispielsweise mit Tellerbürsten, Ultraschall-Reinigungsanlagen, Läppen oder anderen mechanischen Verfahren. Chemische Verfahren sind im Fall von Aluminiumoxid aufgrund seiner hohen chemischen Beständigkeit nicht sinnvoll einsetzbar. Durch den Einsatz entsprechender IR-Laser entstehen keine Stäbe und Aufwurf, die entfernt werden müssen. Eine entsprechende Aufreinigung kann daher vermieden werden.

Alternative b : Durchschneiden des Metall-Keramik-Substrats unter Verwendung eines <u>Laserstrahls</u>

Teilweise besteht Bedarf, Konturen in die Metall-Keramik-Substrate einzubringen, die von einer geraden Linie abweichen. Hierbei kann es sich beispielsweise um Löcher in der Mitte eines Metall-Keramik-Substrats oder um Abrundungen an den Ecken des Metall-Keramik-Substrats handeln. Solche Konturen können erhalten werden, in dem die Keramik des metall-Keramik-Substrats unter Anwendung des Lasers durchschnitten wird.

Wenn im Rahmen der vorliegenden Erfindung das Keramiksubstrat mittels eines Lasers durchschnitten wird, liegt kein Einstichpunkt vor, bei dem ein initiales Durchtrennen der Keramik stattgefunden hat. Daher ist es im Rahmen der vorliegenden Erfindung auch nicht notwendig, außerhalb der Kontur einzustechen und mit einer Anfahrtrampe sich der eigentlichen Schneidkontur anzunähern.

Wenn im Rahmen der vorliegenden Erfindung das Keramiksubstrat unter Anwendung des Lasers durchtrennt wird, weisen die Schneidflanken einen Winkel auf, der üblicherweise um vorzugsweise maximal 30 °, weiter bevorzugt maximal 25 °, von einem rechten Winkel abweicht. Daraus ergibt sich ein Loch, dass auf der Oberseite größer als auf der Unterseite ist.

Ein weiterer Vorteil der Durchtrennung des Keramiksubstrats mit einem IR-Laser, insbesondere p-sec-IR-Laser, ist, dass an der Unterseite, d.h. der Laseraustrittseite, keine durch Schmelzphase gebildeten Grate entstehen, die in einem zusätzlichen Verfahrensschritt entfernt werden müssten.

Vorteile der Alternativen a. und b. Unter Berücksichtigung der oben beschriebenen Alternativen a. und b. ist es möglich, die Metallbeschichtung und das Keramik-Substrat mit demselben Laser zu bearbeiten. Hierdurch lässt sich kostengünstig eine Fertigung von Metall-Keramik-Substraten mit strukturierter Metallbeschichtung realisieren. Im Detail ist es möglich,

I) nur die obere Metallbeschichtung teilweise abzutragen oder bis zur Keramik zu durchtrennen und beispielsweise feine Strukturen in der Metallbeschichtung zu erzeugen, die mit einem Ätzvorgang nicht möglich sind;

II) die Metallbeschichtung und das Keramik-Substrat bis zur unteren Metallbeschichtung zu durchtrennen (Damit kann die Grundlage für Durchkontaktierung geschaffen werden. Füllt man entsprechende Sacklöcher mit einem leitfähigen Material, ist eine Durchkontaktierung hergestellt. Als Füllmaterial eignen sich beispielsweise metallische Pasten oder galvanischen erzeugte Materialien.);

III) Metallbeschichtung und Keramik-Substrat zu durchtrennen bzw. nur die Metallbeschichtung oder das Keramik-Substrat zu durchtrennen, sofern auf der Oberseite des Keramik-Substrats keine Metallbeschichtung vorliegt (beispielsweise weil es bereits weggeätzt wurde oder gar nicht erst aufgebracht wurde).

Das erfindungsgemäße Verfahren der Bearbeitung eines Metall-Keramik-Substrates gemäß Alternativen a. und b. wird vorzugsweise in Gegenwart eines Prozessgases durchgeführt, wobei als Prozessgas beispielsweise Sauerstoff oder Druckluft verwendet werden kann. Wie bereits oben ausgeführt, ist die Verwendung eines Prozessgases nicht zwingend erforderlich, kann jedoch angeraten sein, um die Strahlquelle vor Verunreinigungen zu schützen. In diesem Fall würde sich die Verwendung von Druckluft als bevorzugte Alternative anbieten.

Da in dem erfindungsgemäßen Verfahren durch die Laserbearbeitung Stäube entstehen, ist es besonders bevorzugt, wenn die verwendete Vorrichtung eine Absaugvorrichtung aufweist, die Stäube absorbiert, welche durch die Laserbearbeitungen entstehen.

Die Absaugvorrichtung kann beispielsweise durch ein absaugendes Rohr oder einen absaugenden Kasten gebildet werden, der das projizierte Laserlicht umhüllt und dessen Unterkante einen Abstand zur Oberfläche des Metall-Keramik-Substrats von vorzugsweise 0,5 bis 10 cm, weiter bevorzugt von 0,75 bis 7,5 cm, noch weiter bevorzugt 1 bis 5 cm, aufweist.

Weiterer Gegenstand der vorliegenden Erfindung ist ein metallisiertes Keramiksubstrat welches nach dem oben beschriebenen Verfahren erhalten wird.

Das erfindungsgemäße Metall-Keramik-Substrat kann einen durchgängigen oder unterbrochenen Ritzgraben aufweisen, der beispielsweise eine Tiefe von mindestens 20 $\mu$m, weiter bevorzugt mindestens 30 $\mu$m, noch weiter bevorzugt mindestens 50 $\mu$m, jeweils bezogen senkrecht auf eine planare Oberfläche des Keramiksubstrats, aufweist.

Bei einem Keramiksubstrat mit einer Schichtdicke von 0,38 mm beträgt die Zieltiefe der Laserritzlinie vorzugsweise 30 bis 120 $\mu$m, weiter bevorzugt 40 bis 110 $\mu$m, noch weiter bevorzugt 50 bis 100 $\mu$m.

Bei einem Keramiksubstrat mit einer Schichtdicke von 0,63 mm beträgt die Zieltiefe der Laserritzlinie vorzugsweise 40 bis 140 $\mu$m, weiter bevorzugt 50 bis 130 $\mu$m, noch weiter bevorzugt 60 bis 120 $\mu$m.

Darüber hinaus weist das Metall-Keramik-Substrat eine Breite des Ritzgrabens von vorzugsweise 15 bis 75 $\mu$m, weiter bevorzugt 20 bis 70 $\mu$m, noch weiter bevorzugt 25 bis 65 $\mu$m, auf.

Das mit dem erfindungsgemäßen Verfahren bearbeitete Keramiksubstrat ist im Wesentlichen frei von Verglasungen an den Seiten der Ritzlinie und innerhalb der Ritzlinie im Wesentlichen frei von Rückständen von Glasphasen. Aufgrund der im Bereich der Ritzlinie gebildeten Mikrorisse ist ein Brechen des Keramiksubstrats ohne Schwierigkeiten möglich.

Das erfindungsgemäße metallisierte Keramiksubstrat kann eine durch die Behandlung mit dem IR-Laser erhaltene Kontur aufweisen, die von einer geraden Linie abweicht und die mittels Durchschneidens des Keramiksubstrats unter Verwendung eines Laserstrahls erzeugt wurde. Darüber hinaus ist es möglich, dass das erfindungsgemäße Metall-Keramik-Substrat Löcher und/oder Abrundungen an den Ecken aufweist, welche mittels des Durchschneidens des Kera-

miksubstrats erzeugt wurden.

Die durch das IR-Laser-Verfahren mit einem p-sec-IR-Laser erhaltene metallisierte Keramiksubstrat weist Schneidflanken mit einem Winkel auf, der um vorzugsweise maximal 30 °, weiter bevorzugt maximal 25 °, von einem rechten Winkel abweicht. Sollten durch das IR-Laser-Verfahren Löcher in das Metall-Keramik-Substrat eingebracht werden, so kann deren Größe auf den beiden Seiten des Keramiksubstrats unterschiedlich sein. Allerdings weist das Metall-Keramik-Substrat vorzugsweise an dem Loch und/oder Abrundung keinen Grat auf.

Durch das erfindungsgemäße IR-Laser-Verfahren sind metallisierte Keramiksubstrate erhältlich, die eine Kodierung auf der Metallbeschichtung des metallisierten Keramiksubstrats aufweisen. Diese Kodierung wird vorzugsweise durch ein Abtragen der Metallbeschichtung durch den IR-Laser bewirkt.

Mit dem erfindungsgemäßen Verfahren sind darüber hinaus metallisierte Keramiksubstrate erhältlich, bei welchen die Metallisierung auf dem Keramiksubstrat mindestens eine Randabschwächung aufweist oder aber in welchen die Metallisierung mindestens eine Vertiefung zur Aufnahme von elektronischen Bauteilen, insbesondere Chips, aufweist, wobei die Vertiefung durch eine Laserbehandlung erzeugt wurde.Die vorliegende Erfindung wind anhand der nachfolgenden Beispiele näher erläutert:

Beispiel 1:

(1) Metallisiertes Keramiksubstrat

Die nachfolgenden Versuche werden an einem metallisierten Keramiksubstrat durchgeführt,

dass mittels des DCB-Verfahrens erhalten wird.

Bei dem Keramiksubstrat handelt es sich um eine $Al_2O_3$-Keramikmaterial. Die Schichtdicke des Keramiksubstrats beträgt 0,38 mm (Versuchsreihe 1) sowie 0,63 mm (Versuchsreihe 2).

(2) Laser

Die nachfolgenden Versuchen werden mit folgendem Laser durchgeführt:

| | |
|---|---|
| Leistung: | 100 W |
| Laserquelle: | IR |
| Pulsdauer Laser: | 0,1 bis 100 ps |
| Pulsenergie Laser: | 10 bis 500 µJ |
| Spot-Durchmesser: | 30 µm |
| Frequenz Laser: | 350 bis 650 kHz |

Mit dem oben beschriebenen Laser wird in das Keramiksubstrat eine Laserritzlinie erzeugt und anschließend wird das Keramiksubstrat in der Laserritzlinie gebrochen.

(3) Ergebnisse

| Versuchsreihe | reale Bearbeitungsgeschwindigkeit | Brechverhalten Keramiksubstrat |
|---|---|---|
| 1 | 7,5 m/sec | + |
| 1 | 10 m/sec | + |
| 1 | 15 m/sec | 0 |
| 1 | 20 m/sec | - |
| 2 | 7,5 m/sec | + |
| 2 | 10 m/sec | + |
| 2 | 15 m/sec | 0 |
| 2 | 20 m/sec | - |

Bewertung:

+: gutes Brechverhalten

0: mittleres Brechverhalten

-: schlechtes Brechverhalten

Die Versuchsreihe zeigt, dass Realgeschwindigkeiten des IR-Lasers zwischen bis 15 m/sec für das Brechverhalten geeignet sind. Höhere Realgeschwindigkeiten des IR-Lasers führen zu einem schlechten Brechverhalten.

Mit diesen Geschwindigkeiten der IR-Lasers werden Glasphasen in der Laserritzlinie im Wesentlichen vermieden und es bilden sich ausreichend Mikrorisse, so dass eine Durchtrennung der Keramik möglich ist.

Realgeschwindigkeiten unterhalb von 0,05 m/sec sind nachteilig, weil zu tiefe Ritzlinien (zu viel Bildung von Glasphasen) entstehen. Darüber hinaus sind Realgeschwindigkeiten unterhalb von 0,05 m/sec aus wirtschaftlichen Gründen benachteiligt.

**Patentansprüche**

1. Verfahren zum Bearbeiten von metallisierten Keramiksubstraten, bei welchen

   a. eine Laserritzlinie als Sollbruchlinie in dem metallisierten Keramiksubstrat unter Verwendung eines Laserstrahls erzeugt wird; und/oder

   b. ein zumindest teilweises Durchschneiden des metallisierten Keramiksubstrats unter Verwendung eines Laserstrahls erfolgt;

   wobei die Bearbeitung unter Verwendung eines p-sec IR-Lasers erfolgt,
   **dadurch gekennzeichnet, dass** das Licht des Lasers von dem Keramiksubstrat und der Metallbeschichtung des metallisierten Keramiksubstrats absorbiert wird, dass bei der Erzeugung der Laserritzlinie als Sollbruchlinie oder bei dem Durchschneiden eine Pulsdauer des Lasers verwendet wird, die so gewählt wird, dass die Laserritzlinie weniger als 30 Vol.-% und mehr als 0,1 Vol.-% Schmelzphase des Keramikmaterials des metallisierten Keramiksubstrats enthält, dass die Bearbeitungsgeschwindigkeit des p-sec-Lasers mindestens 0,05 m/sec und höchstens 19 m/sec beträgt und die Tiefe der Laserritzlinie 5 bis 50 % der Schichtdicke des Keramiksubstrats beträgt.

2. Verfahren nach Anspruch 1, **dadurch gekennzeichnet, dass** die Laserritzlinie durchgängig oder unterbrochen ausgebildet ist.

3. Verfahren nach Anspruch 1 oder 2, **dadurch gekennzeichnet, dass** der Laser eine Pulsdauer von 0,1 bis 100 ps aufweist.

4. Verfahren nach einem der Ansprüche 1 bis 3, **dadurch gekennzeichnet, dass** bei der Erzeugung der Laserritzlinie als Sollbruchlinie die Laserritzlinie in mehreren Überfahrten des Lasers erzeugt wird und/oder das zumindest teilweise Durchschneiden des metallisierten Keramiksubstrats in mehreren Überfahrten des Lasers erfolgt.

5. Verfahren nach Anspruch 4, **dadurch gekennzeichnet, dass** der IR-Laser eine Leistung von 60 bis 160 Watt aufweist.

6. Verfahren nach Anspruch 1 bis 5, **dadurch gekennzeichnet, dass** die Frequenz des IR-Lasers 350 bis 650 kHz beträgt.

7. Verfahren nach einem der Ansprüche 1 bis 6, **dadurch gekennzeichnet, dass** die Pulsenergie des IR-Lasers 100 bis 300 μJ beträgt.

8. Verfahren nach einem der Ansprüche 1 bis 7, **dadurch gekennzeichnet, dass** der Spot-Durchmesser des IR-Lasers 20 bis 100 μm beträgt.

9. Verfahren nach einem der Ansprüche 1 bis 8, **dadurch gekennzeichnet, dass** das Verfahren in einer Vorrichtung durchgeführt wird, die eine Absaugvorrichtung aufweist, die Stäube absorbiert, welche durch die Laserbearbeitungen entstehen.

10. Metallisiertes Keramiksubstrat, erhältlich nach einem Verfahren gemäß einem der Ansprüche 1 bis 9, welches eine Laserritzlinie aufweist,

**dadurch gekennzeichnet, dass**

die Laserritzlinie weniger als 30 Vol.-% und
mehr als 0,1 Vol.-% Schmelzphase des Keramikmaterials des metallisierten Keramiksubstrats enthält,
und dass die Tiefe der Laserritzlinie 5 bis 50 % der Schichtdicke des Keramiksubstrats beträgt.

**11.** Metallisiertes Keramiksubstrat nach Anspruch 10, **dadurch gekennzeichnet, dass** das Keramiksubstrat einen durchgängigen Ritzgraben aufweist.

**12.** Metallisiertes Keramiksubstrat nach Anspruch 10 oder 11, **dadurch gekennzeichnet, dass** das Keramiksubstrat einen durchgängigen Ritzgraben mit einer Tiefe von mindestens 20 $\mu$m, jeweils bezogen senkrecht auf eine planare Oberfläche des Keramiksubstrats, aufweist.

**13.** Metallisiertes Keramiksubstrat nach Anspruch 10, **dadurch gekennzeichnet, dass** das Keramiksubstrat eine Kontur aufweist, die von einer geraden Linie abweicht und die mittels Durchschneidens des Keramiksubstrats unter Verwendung eines Laserstrahls erzeugt wurde.

**Claims**

**1.** A method for processing metallized ceramic substrates, wherein

a. a laser scribe line is generated as a predetermined breaking line in the metallized ceramic substrate using a laser beam; and/or
b. an at least partial cutting through of the metallized ceramic substrate is carried out using a laser beam;

wherein the processing is performed using a p-sec IR laser, **characterized in that** the light of the laser is absorbed by the ceramic substrate and the metal coating of the metallized ceramic substrate, **in that** in the generation of the laser scribe line as a nominal break line or in the cutting through a pulse duration of the laser is used which is selected such that the laser scribe line contains less than 30 vol. % and more than 0.1 vol. % of the melt phase of the ceramic material of the metallized ceramic substrate, that the processing speed of the p-sec laser is at least 0.05 m/sec and at most 19 m/sec and the depth of the laser scribe line is 5 to 50 % of the layer thickness of the ceramic substrate.

**2.** Method according to claim 1, **characterized in that** the laser scribe line is continuous or interrupted.

**3.** Method according to claim 1 or 2, **characterized in that** the laser has a pulse duration of 0.1 to 100 ps.

**4.** Method according to any one of claims 1 to 3, **characterized in that** when the laser scribe line is generated as a predetermined breaking line, the laser scribe line is generated in multiple passes of the laser and/or the at least partial cutting through of the metallized ceramic substrate is performed in multiple passes of the laser.

**5.** Method according to claim 4, **characterized in that** the IR laser has a power of 60 to 160 watts.

**6.** Method according to claim 1 to 5, **characterized in that** the frequency of the IR laser is 350 to 650 kHz.

**7.** Method according to any one of claims 1 to 6, **characterized in that** the pulse energy of the IR laser is 100 to 300 $\mu$J.

**8.** Method according to any one of claims 1 to 7, **characterized in that** the spot diameter of the IR laser is 20 to 100 $\mu$m.

**9.** Method according to any one of claims 1 to 8, **characterized in that** the method is carried out in an apparatus comprising an exhaust device that absorbs dusts generated by the laser machining operations.

**10.** Metallized ceramic substrate obtainable by a process according to any one of claims 1 to 9, which has a laser scribe line, **characterized in that** the laser scribe line contains less than 30 vol.% and more than 0.1 vol.% of melt phase of the ceramic material of the metallized ceramic substrate, and that the depth of the laser scribe line is 5 to 50% of the layer thickness of the ceramic substrate.

11. Metallized ceramic substrate of claim 10, **characterized in that** the ceramic substrate has a continuous scribe trench.

12. Metallized ceramic substrate of claim 10 or 11, **characterized in that** the ceramic substrate has a continuous scribe trench having a depth of at least 20 μm, each perpendicular to a planar surface of the ceramic substrate.

13. Metallized ceramic substrate of claim 10, **characterized in that** the ceramic substrate has a contour that deviates from a straight line and that has been created by cutting through the ceramic substrate using a laser beam.

**Revendications**

1. Un procédé de traitement de substrats céramiques métallisés dans lequel

    a. une ligne de traçage laser est générée comme ligne de rupture prédéterminée dans le substrat céramique métallisé en utilisant un faisceau laser ; et/ou
    b. une découpe au moins partielle du substrat céramique métallisé est effectuée à l'aide d'un faisceau laser ;

    dans lequel le traitement est effectué à l'aide d'un laser IR p-sec,
    **caractérisé en ce que** la lumière du laser est absorbée par le substrat céramique et le revêtement métallique du substrat céramique métallisé, **en ce que**, lors de la génération de la ligne de traçage laser en tant que ligne de rupture nominale ou lors de la découpe, on utilise une durée d'impulsion du laser qui est choisie de telle sorte que la ligne de traçage laser soit inférieure à 30 % en volume et plus de 0,1 % en volume de la phase fondue du matériau céramique du substrat céramique métallisé, que la vitesse de traitement du laser p-sec est d'au moins 0,05 m/sec et d'au plus 19 m/sec et que la profondeur de la ligne de traçage laser est de 5 à 50 % de l'épaisseur de la couche du substrat céramique.

2. Procédé selon la revendication 1, **caractérisé en ce que** la ligne de traçage laser est continue ou interrompue.

3. Procédé selon la revendication 1 ou 2, **caractérisé en ce que** le laser a une durée d'impulsion de 0,1 à 100 ps.

4. Procédé selon l'une quelconque des revendications 1 à 3, **caractérisé en ce que**, lors de la génération de la ligne de traçage laser comme ligne de rupture prédéterminée, la ligne de traçage laser est générée en plusieurs passages du laser et/ou la découpe au moins partielle du substrat céramique métallisé a lieu en plusieurs passages du laser.

5. Procédé selon la revendication 4, **caractérisé en ce que** le laser IR a une puissance de 60 à 160 watts.

6. Procédé selon la revendication 1 à 5, **caractérisé en ce que** la fréquence du laser IR est de 350 à 650 kHz.

7. Procédé selon l'une quelconque des revendications 1 à 6, **caractérisé en ce que** l'énergie d'impulsion du laser IR est de 100 à 300 μJ.

8. Procédé selon l'une quelconque des revendications 1 à 7, **caractérisé en ce que** le diamètre du spot du laser IR est de 20 à 100 μm.

9. Procédé selon l'une quelconque des revendications 1 à 8, **caractérisé en ce que** le procédé est mis en œuvre dans un appareil comprenant un dispositif d'aspiration qui absorbe les poussières générées par les opérations d'usinage au laser.

10. Substrat céramique métallisé pouvant être obtenu par un procédé selon l'une quelconque des revendications 1 à 9, qui présente une ligne de traçage laser, **caractérisé en ce qu'**il contient moins de 30% en volume et plus de 0,1% en volume de phase fondue du matériau céramique du substrat céramique métallisé, et que la profondeur de la ligne de traçage laser est de 5 à 50% de l'épaisseur de couche du substrat céramique.

11. Substrat céramique métallisé de la revendication 10, **caractérisé en ce que** le substrat céramique a une tranchée de rayure continue.

12. Substrat céramique métallisé selon la revendication 10 ou 11, **caractérisé en ce que** le substrat céramique présente une tranchée de rayure continue d'une profondeur d'au moins 20 μm, dans chaque cas perpendiculaire à une surface plane du substrat céramique.

13. Substrat céramique métallisé selon la revendication 10, **caractérisé en ce que** le substrat céramique a un contour qui s'écarte d'une ligne droite et qui a été produit en coupant à travers le substrat céramique en utilisant un faisceau laser.

**IN DER BESCHREIBUNG AUFGEFÜHRTE DOKUMENTE**

**In der Beschreibung aufgeführte Patentdokumente**

- US 2003213770 A1